# EUROPEAN PATENT APPLICATION

(11) **EP 4 253 595 A1**
(43) Date of publication of application: **04.10.2023**
(21) Application number: 23724159.1
(22) Date of filing: 05.01.2023
(51) Int. Cl.: C23C 16/04, C23C 16/455, C23C 16/40, H01L 21/02

(54) **OXIDE FILM REACTION SURFACE CONTROL AGENT, METHOD FOR FORMING OXIDE FILM BY USING SAME, AND SEMICONDUCTOR SUBSTRATE AND SEMICONDUCTOR DEVICE MANUFACTURED THEREFROM**

(30) Priority: 10.02.2022 KR 20220017688; 25.10.2022 KR 20220138087
(71) Applicant: Soulbrain Co., Ltd., Seongnam-si, Gyeonggi-do 13486 (KR)
(72) Inventor: LEE, Seung Hyun, Seongnam-si, Gyeonggi-do 13486 (KR); JUNG, Jae Sun, Seongnam-si, Gyeonggi-do 13486 (KR); YEON, Chang Bong, Seongnam-si, Gyeonggi-do 13486 (KR); KIM, Deok Hyun, Seongnam-si, Gyeonggi-do 13486 (KR)
(74) Representative: Dehns
(86) International application number: PCT/KR2023/000207
(87) International publication number: WO 2023/153647

(57) **Abstract**

The present invention relates to an oxide film reaction surface control agent, a method of forming an oxide film using the oxide film reaction surface control agent, a semiconductor substrate including the oxide film, and a semiconductor device including the semiconductor substrate. According to the present invention, by providing a compound having a predetermined structure as an oxide film reaction surface control agent, a deposition layer having a uniform thickness due to a difference in the adsorption distribution of the oxide film reaction surface control agent is formed as a shielding area on a substrate, thereby reducing thin film deposition rate and appropriately reducing thin film growth rate. Accordingly, even when a thin film is formed on a substrate having a complex structure, step coverage and the thickness uniformity of the thin film may be greatly improved, and impurities may be reduced.

## Description

### [Technical Field]

The present invention relates to an oxide film reaction surface control agent, a method of forming an oxide film using the oxide film reaction surface control agent, a semiconductor substrate including the oxide film, and a semiconductor device including the semiconductor substrate. According to the present invention, by providing a compound having a predetermined structure as an oxide film reaction surface control agent to form a deposition layer having a uniform thickness due to a difference in adsorption distribution as a shielding area on a substrate, thin film deposition rate may be reduced, and thin film growth rate may be appropriately reduced. Accordingly, even when forming a thin film on a substrate having a complex structure, step coverage and thickness uniformity of the thin film may be greatly improved, and impurities may be greatly reduced.

### [Background Art]

Due to increase in the degree of integration of memory and non-memory semiconductor devices, the microstructures of substrates are becoming increasingly complex.

For example, the ratio of the width to the depth of a microstructure (hereinafter also referred to as 'aspect ratio') is 20:1 or more or 100:1 or more. As the aspect ratio increases, it is difficult to form a deposition layer with a uniform thickness in a complex microstructure.

Accordingly, step coverage defined by the thickness ratio of deposition layers formed on the top and bottom of a microstructure in the depth direction is about 90 %, which makes it difficult to express the electrical characteristics of a device. A step coverage of 100 % means that deposition layers formed on the top and bottom of a microstructure have the same thickness. Accordingly, it is necessary to develop technology capable of bringing a step coverage value close to 100 %.

Thin films for semiconductors may be classified into nitride films, oxide films, and metal films. The nitride films include silicon nitride (SiN) films, titanium nitride (TiN) films, and tantalum nitride (TaN) films, the oxide films include silicon oxide (SiO₂) films, hafnium oxide (HfO₂) films, and zirconium oxide (ZrO₂) films, and the metal films include molybdenum (Mo) films and tungsten (W) films.

In general, the thin film serves as a diffusion barrier between the silicon layer of a doped semiconductor and aluminum (Al) or copper (Cu) used as an interlayer wiring material. Exceptionally, when depositing a tungsten (W) thin film on a substrate, the thin film acts as an adhesion layer.

As described above, to impart excellent and uniform physical properties to a thin film deposited on a substrate, it is essential that the thin film has high step coverage. Accordingly, an atomic layer deposition (ALD) process using a surface reaction is used rather than a chemical vapor deposition (CVD) process using a gas phase reaction. However, it is still difficult to achieve 100 % step coverage.

When deposition temperature is increased for the purpose of realizing 100 % step coverage, an increase in deposition temperature during a deposition process involving two components of a precursor and a reactant results in a sharp increase in thin film growth rate (GPC). In addition, Even when an ALD process is performed at 300 °C to inhibit increase in GPC due to increase in deposition temperature, deposition temperature increases during the process. Thus, this method cannot be a solution either.

In addition, in fabricating a semiconductor device, a high-temperature process is required to realize an excellent metal oxide film. It has been reported that the concentration of carbon and hydrogen remaining in a thin film may be reduced by increasing atomic layer deposition temperature up to 400 °C (see J. Vac. Sci. Technol. A, 35(2017) 01B130).

However, as the deposition temperature increases, it becomes difficult to secure step coverage. First, an increase in deposition temperature during a deposition process involving two components of a precursor and a reactant may result in a sharp increase in thin film growth rate (GPC). In addition, even when a known shielding agent is used to inhibit increase in GPC due to increase in deposition temperature, GPC increases by about 10 % at 300 °C. That is, when deposition is performed at 360 °C or higher, it is difficult to expect a GPC reduction effect provided by a conventionally known shielding agent.

Therefore, it is necessary to develop a thin-film formation method that allows formation of a thin film with a complex structure effectively even at high temperatures, reduces the amount of residual impurities, and greatly improves step coverage and the thickness uniformity of a thin film and a semiconductor substrate fabricated using the method.

### [Disclosure]

### [Technical Problem]

Therefore, the present invention has been made in view of the above problems, and it is one object of the present invention to provide an oxide film reaction surface control agent, a method of forming an oxide film using the oxide film reaction surface control agent, and a semiconductor substrate including the oxide film. According to the present invention, by forming a deposition layer having a uniform thickness due to a difference in the adsorption distribution of an oxide film reaction surface control agent as a shielding area for thin films on a substrate, thin film deposition rate may be reduced, and thin film growth rate may be appropriately reduced. Accordingly, even when forming a thin film on a substrate having a complex structure, step coverage and thickness uniformity of the thin film may be greatly improved.

It is another object of the present invention to improve the density and dielectric properties of a thin film by improving the crystallinity and oxidation fraction of the thin film.

The above and other objects can be accomplished by the present invention described below.

### [Technical Solution]

In accordance with one aspect of the present invention, provided is an oxide film reaction surface control agent including one or more compounds selected from a cyclic compound containing three or more elements having an unshared electron pair and a linear compound containing three or more elements having an unshared electron pair, wherein the oxide film reaction surface control agent controls a reaction surface of an oxide film formed of one or more metals selected from a trivalent metal, a tetravalent metal, a pentavalent metal, and a hexavalent metal.

The elements having an unshared electron pair may include one or more selected from oxygen (0), sulfur (S), phosphorus (P), and nitrogen (N).

The cyclic compound containing three or more elements having an unshared electron pair may be a compound represented by Chemical Formula 1 below:

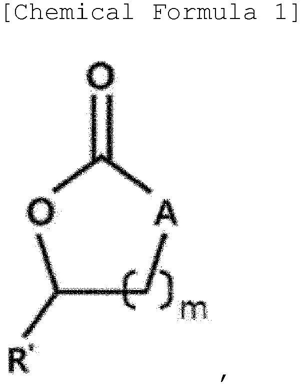

wherein R' is hydrogen, an alkyl group having 1 to 5 carbon atoms, an alkene group having 1 to 5 carbon atoms, or an alkoxy group having 1 to 5 carbon atoms,

A is oxygen (O), sulfur (S), phosphorus (P), or nitrogen (N), and
m is an integer from 0 to 2.

The linear compound containing three or more elements having an unshared electron pair may be a compound represented by Chemical Formula 2 below:

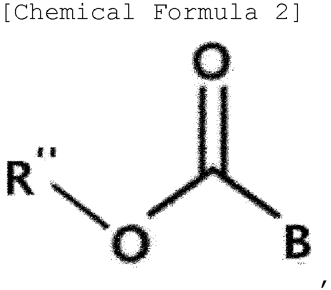

wherein R'' is hydrogen, an alkyl group having 1 to 5 carbon atoms, an alkene group having 1 to 5 carbon atoms, or an alkoxy group having 1 to 5 carbon atoms, and
B is -OH, -OCH₃, -OCH₂CH₃, -CH₂CH₃, -SH, -SCH₃, or-SCH₂CH₃.

The oxide film reaction surface control agent may have a refractive index (measured at 20 to 25 °C) of 1.365 to 1.48, 1.366 to 1.47, 1.367 to 1.46, 1.365 to 1.41, or 1.41 to 1.46.

The oxide film reaction surface control agent may include one or more selected from compounds represented by Chemical Formulas 1-1 to 1-3 below and compounds represented by Chemical Formulas 2-1 to 2-3 below:

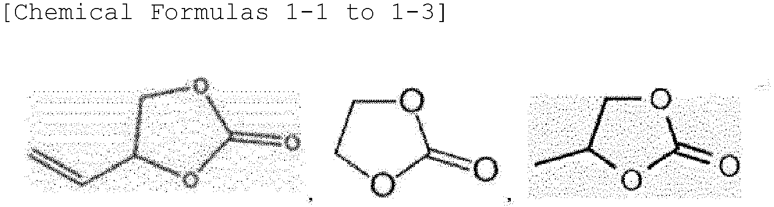

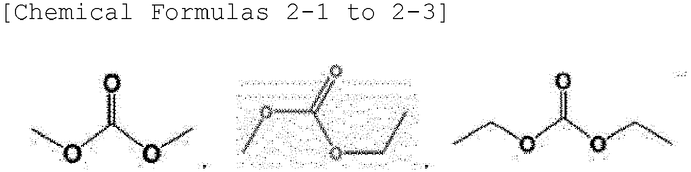

The metal may control a reaction surface of an oxide film formed of one or more precursor compounds selected from the group consisting of Al, Si, Ti, V, Co, Ni, Cu, Zn, Ga, Ge, Se, Zr, Nb, Mo, Ru, Rh, In, Sn, Sb, Te, Hf, Ta, W, Re, Os, Ir, La, Ce, and Nd.

In accordance with another aspect of the present invention, provided is a method of forming an oxide film, the method including:
treating a surface of a substrate with the above-described oxide film reaction surface control agent; and
sequentially injecting a precursor compound and a reaction gas into a chamber loaded with the substrate to form an oxide film on the surface of the substrate.

The chamber may be an ALD chamber, a CVD chamber, a PEALD chamber, or a PECVD chamber.

The treating may be performed by applying the oxide film reaction surface control agent at 20 to 800 °C onto the substrate loaded in the chamber.

The oxide film reaction surface control agent and the precursor compound may be transferred into the chamber by a VFC method, a DLI method, or an LDS method, and The thin film may be a silicon oxide film, a titanium oxide film, a hafnium oxide film, a zirconium oxide film, a tungsten oxide film, an aluminum oxide film, a niobium oxide film, or a tellurium oxide film.

The reaction gas may include O₂, O₃, N₂O, NO₂, H₂O, or O₂ plasma.

The oxide film may be a thin film having two or more layers formed by laminating one or more metals selected from the group consisting of Al, Si, Ti, V, Co, Ni, Cu, Zn, Ga, Ge, Se, Zr, Nb, Mo, Ru, Rh, In, Sn, Sb, Te, Hf, Ta, W, Re, Os, Ir, La, Ce, and Nd.

The thin film may be used as a diffusion barrier film, an etching stop film, an electrode film, a dielectric film, a gate insulating film, a block oxide film, or a charge trap.

In accordance with still another aspect of the present invention, provided is a method of forming an oxide film, the method including:
i) vaporizing the oxide film reaction surface control agent described above to form a shielding area on a surface of a substrate loaded in a chamber;
ii) primarily purging an inside of the chamber with a purge gas;
iii) vaporizing a precursor compound to adsorb the precursor compound to an area outside the shielding area;
iv) secondarily purging the inside of the chamber with a purge gas;
v) supplying a reaction gas into the chamber; and
vi) thirdly purging the inside of the chamber with a purge gas.

In the activating of a reaction surface, a substrate with an activated surface may be manufactured by applying the oxide film reaction surface control agent at 20 to 800 °C onto a substrate loaded in the chamber.

The precursor compound may be a compound consisting of one or more selected from the group consisting of Al, Si, Ti, V, Co, Ni, Cu, Zn, Ga, Ge, Se, Zr, Nb, Mo, Ru, Rh, In, Sn, Sb, Te, Hf, Ta, W, Re, Os, Ir, La, Ce, and Nd, and may have a vapor pressure of greater than 0.01 mTorr and 100 Torr or less at 25 °C.

The precursor compound may be vaporized and injected, followed by plasma post-treatment.

In step ii) and step iv), an amount of the purge gas introduced into the chamber may be 10 to 100,000 times a volume of the oxide film reaction surface control agent.

The reaction gas may be an oxidizer, and the reaction gas, the oxide film reaction surface control agent, and the precursor compound may be transferred into the chamber by a VFC method, a DLI method, or an LDS method.

The substrate loaded in the chamber may be heated at 100 to 800 °C, and an input ratio (mg/cycle) of the oxide film reaction surface control agent to the precursor compound introduced into the chamber may be 1:1 to 1:20.

In accordance with still another aspect of the present invention, provided is a semiconductor substrate including the oxide film formed by the method of forming an oxide film described above.

The oxide film may be a multilayer structure having two or more layers.

In accordance with yet another aspect of the present invention, provided is a semiconductor device including the semiconductor substrate described above.

The semiconductor device may be low-resistance metal gate interconnects, a high aspect-ratio 3D metal-insulator-metal (MIM) capacitor, a DRAM trench capacitor, 3D gate-all-around (GAA), or a 3D NAND flash memory.

### [Advantageous Effects]

The present invention has an effect of providing an oxide film reaction surface control agent capable of effectively shielding adsorption on the surface of a substrate to reduce reaction rate and appropriately reduce thin film growth rate. According to the present invention, even when a thin film is formed on a substrate having a complex structure, step coverage can be improved.

In addition, corrosion or deterioration can be prevented by effectively reducing by-products during thin film formation, and the crystallinity of a thin film can be improved through thin film modification, thereby improving the electrical properties of the thin film.

In addition, when forming a thin film, by-products can be reduced and step coverage and the density of the thin film can be improved. In addition, the present invention has an effect of providing a method of forming an oxide film using the oxide film reaction surface control agent and a semiconductor substrate including the oxide film.

### [Description of Drawings]

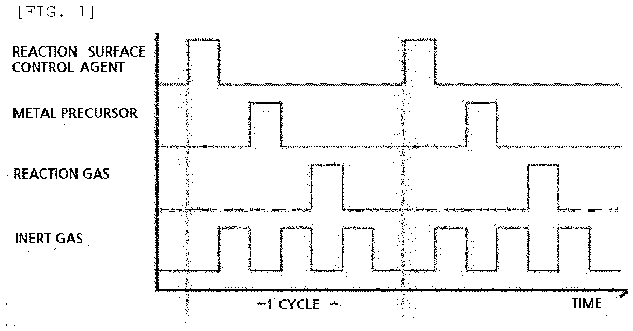

FIG. 1 is a diagram schematically showing a deposition process sequence according to the present invention based on 1 cycle.

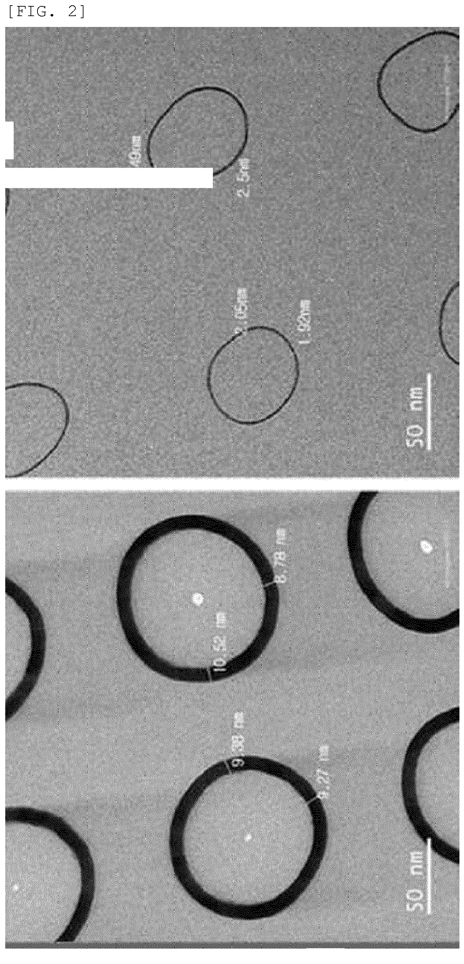

FIG. 2 includes TEM images showing the thickness of the upper portion (100 nm below the top) and lower portion (100 nm above the bottom) of the cross-section of an oxide film deposited without using an oxide film reaction surface control agent according to Comparative Example 1 and TEM images showing the thickness of the upper portion (100 nm below the top) and lower portion (100 nm above the bottom) of the cross-section of an oxide film deposited using an oxide film reaction surface control agent.

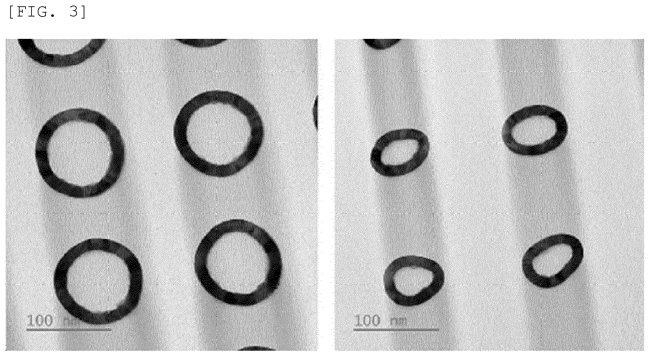

FIG. 3 includes TEM images showing the thickness of the upper portion (100 nm below the top) and lower portion (100 nm above the bottom) of the cross-section of an oxide film deposited using an oxide film reaction surface control agent according to Example 3 and TEM images showing the thickness of the upper portion (100 nm below the top) and lower portion (100 nm above the bottom) of the cross-section of an oxide film deposited using an oxide film reaction surface control agent.

### [Best Mode]

Hereinafter, an oxide film reaction surface control agent of the present invention, a method of forming an oxide film using the oxide film reaction surface control agent, and a semiconductor substrate including the oxide film will be described in detail.

In the present disclosure, unless otherwise specified, the term "reaction surface control" means controlling a substrate surface to be used as a reaction surface in a deposition process so that a precursor compound is adsorbed to the substrate surface at a reduced reaction rate.

In the present disclosure, unless otherwise specified, the term "shielding" means reducing, preventing, or blocking adsorption of a precursor compound for forming a thin film on a substrate and at the same time, reducing, preventing, or blocking adsorption of by-products on the substrate.

The present inventors confirmed that, when a compound having a predetermined structure was used as an oxide film reaction surface control agent for reducing the adsorption rate of a reaction surface reacting with a precursor compound for forming an oxide film on a substrate loaded inside a chamber, and a deposition layer having a uniform thickness due to a difference in the adsorption distribution of the oxide film reaction surface control agent was formed as a shielding area that does not remain in a thin film, a relatively coarse thin film was formed, and the growth rate of the formed thin film was significantly reduced. Thus, even when the thin film was applied to a substrate with a complex structure at high temperature, the uniformity of the thin film was secured and step coverage was greatly improved. In particular, deposition could be performed with thin thickness, and the amount of O, Si, metal, and metal oxide remaining as by-products was reduced. In addition, residual carbon, which was previously difficult to reduce, was reduced. Based on these results, the present inventors completed the present invention by concentrating on research on an oxide film reaction surface control agent that provides a shielding area.

The oxide film reaction surface control agent of the present invention controls the reaction surface of a substrate on which an oxide film is to be formed.

For example, the thin film may be formed of one or more precursors selected from the group consisting of Al, Si, Ti, V, Co, Ni, Cu, Zn, Ga, Ge, Se, Zr, Nb, Mo, Ru, Rh, In, Sn, Sb, Te, Hf, Ta, W, Re, Os, Ir, La, Ce, and Nd, and may provide an oxide film, a nitride film, a metal film, or a shielding area for a selective thin film thereof. In this case, the effects of the present invention may be sufficiently obtained.

As a specific example, the thin film may have a film composition of a silicon oxide film, a titanium oxide film, a hafnium oxide film, a zirconium oxide film, a tungsten oxide film, an aluminum oxide film, a niobium oxide film, or a tellurium oxide film.

In addition to a diffusion barrier film, the thin film may be used as an etching stop film, an electrode film, a dielectric film, a gate insulating film, a block oxide film, or a charge trap used in semiconductor devices.

According to the present invention, the precursor compound used to form the thin film may be a molecule containing one or more ligands selected from C, N, O, H, halogen (X), and cyclopentadiene (Cp) and one or more selected from the group consisting of Al, Si, Ti, V, Co, Ni, Cu, Zn, Ga, Ge, Se, Zr, Nb, Mo, Ru, Rh, In, Sn, Sb, Te, Hf, Ta, W, Re, Os, Ir, La, Ce, and Nd as a central metal atom (M), and may have a vapor pressure of 1 mTorr to 100 Torr at 25 °C.

For example, the precursor compound may be a compound represented by Chemical Formula 3 below.

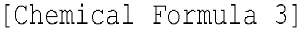

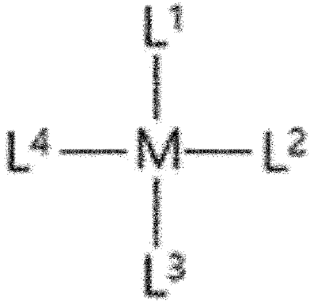

In Chemical Formula 3, M may include one or more selected from Al, Si, Ti, V, Co, Ni, Cu, Zn, Ga, Ge, Se, Zr, Nb, Mo, Ru, Rh, In, Sn, Sb, Te, Hf, Ta, W, Re, Os, Ir, La, Ce, and Nd, and L1, L2, L3, and L4 may each independently be -H, -X, -R, -OR, -NR2, or cyclopentadiene (Cp), and may be the same or different from each other. Here, -X may be F, Cl, Br, or I, -R may be linear or cyclic C1-C10 alkyl, C1-C10 alkene, or C1-C10 alkane, and L1, L2, L3, and L4 may be formed from 2 to 6 depending on the oxidation number of the central metal.

For example, when the central metal is bivalent, L1 and L2 may be attached to the central metal as ligands. When the central metal is hexavalent, L1, L2, L3, L4, L5, and L6 may be attached to the central metal, and ligands of L1 to L6 may be the same or different from each other.

M may be a trivalent metal, a tetravalent metal, a pentavalent metal, or a hexavalent metal, preferably hafnium (Hf), zirconium (Zr), aluminum (Al), niobium (Nb), or tellurium (Te). In this case, by-products may be significantly reduced, step coverage may be excellent, thin film density may be improved, and the electrical properties, insulation, and dielectric properties of a thin film may be excellent.

L1, L2, L3 and L4 may each independently be -R, -X, or Cp, and may be the same or different from each other. Here, -R may be linear or cyclic C1-C10 alkyl, C1-C10 alkene, or C1-C10 alkane.

In addition, L1, L2, L3, and L4 may each independently be -NR2 or Cp, and may be the same or different from each other. Here, -R may be H, C1-C10 alkyl, C1-C10 alkene, C1-C10 alkane, iPr, or tBu.

In addition, in Chemical Formula 8, L1, L2, L, and L4 may each independently be -H or -X, and may be the same or different from each other. Here, -X may be F, Cl, Br, or I.

As a specific example, Al(CH₃)₃, AlCl₄, or the like may be used as the aluminum precursor compound.

For example, as the hafnium precursor compound, tris(dimethylamido)cyclopentadienyl hafnium of CpHf(NMe₂)₃), (methyl-3-cyclopentadienylpropylamino)bis(dimethylamino)hafnium of Cp(CH₂)₃NM₃Hf(NMe₂)₂, or the like may be used.

The oxide film reaction surface control agent of the present invention may reduce the adsorption rate of the precursor compound on a substrate by pre-controlling the reaction surface of the substrate to which the precursor compound is adsorbed.

For example, the shielding area may be all or part of the substrate on which the thin film is formed.

In addition, for example, when the total area of the substrate is 100 %, the shielding area may account for 10 to 95 %, as a specific example, 15 to 90 %, preferably 20 to 85 %, more preferably 30 to 80 %, still more preferably 40 to 75 %, still more preferably 40 to 70 %, and the remaining area may be a non-shielding area.

In addition, when the total area of the substrate is 100 %, a first shielding area may account for 10 to 95 %, as a specific example, 15 to 90 %, preferably 20 to 85 %, more preferably 30 to 80 %, still more preferably 40 to 75 %, still more preferably 40 to 70 %. In the remaining area, a second shielding area may account for 10 to 95 %, as a specific example, 15 to 90 %, preferably 20 to 85 %, more preferably 30 to 80 %, still more preferably 40 to 75 %, still more preferably 40 to 70 %, and the remaining area may be a non-shielding area.

The oxide film reaction surface control agent may provide a controlled reaction surface on the surface of the substrate on which the aforementioned thin film is to be provided.

The oxide film reaction surface control agent may have 3 or more nitrogen (N) atoms, oxygen (O) atoms, phosphorus (P) atoms, or sulfur (S) atoms, and may include linear or cyclic saturated hydrocarbons having 3 to 15 carbon atoms or linear saturated hydrocarbons. In this case, when forming a thin film, a relatively coarse thin film may be formed by forming a shielding area that does not remain on the thin film. At the same time, side reactions may be suppressed, and thin film growth rate may be controlled, thereby reducing by-products in the thin film, preventing corrosion or deterioration, and improving the crystallinity of the thin film. In addition, when forming a metal oxide film, a stoichiometric oxidation state may be reached. Even when a thin film is formed on a substrate having a complex structure, step coverage and the thickness uniformity of the thin film may be greatly improved.

As a specific example, the oxide film reaction surface control agent has a structure in which nitrogen (N), oxygen (O), phosphorus (P), or sulfur (S) is independently bonded to both ends of a central carbon atom bonded to oxygen by a double bond. Due to these structural features, by-products may be significantly reduced, step coverage may be excellent, thin film density may be improved, and the electrical properties of a thin film may be excellent.

Here, unless otherwise specified, the above-described structure in which nitrogen (N), oxygen (O), phosphorus (P), or sulfur (S) is independently bonded to both ends of a central carbon atom bonded to oxygen by a double bond is

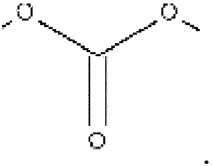

As a specific example, the oxide film reaction surface control agent has a structure in which nitrogen (N), oxygen (O), phosphorus (P), or sulfur (S) is bonded to one end of a central carbon atom bonded to oxygen by a double bond and carbon (C) is bonded to the other end thereof. Due to these structural features, by-products may be significantly reduced, step coverage may be excellent, thin film density may be improved, and the electrical properties of a thin film may be excellent.

Here, unless otherwise specified, the above-described structure in which nitrogen (N), oxygen (O), phosphorus (P), or sulfur (S) is bonded to one end of a central carbon atom bonded to oxygen by a double bond and carbon (C) is bonded to the other end thereof is

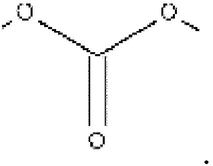

As a specific example, the oxide film reaction surface control agent includes one or more compounds selected from a cyclic compound containing three or more elements having an unshared electron pair and a linear compound containing three or more elements having an unshared electron pair. In this case, a relatively coarse thin film may be formed by controlling the reaction surface of an oxide film formed of one or more metals selected from a trivalent metal, a tetravalent metal, a pentavalent metal, and a hexavalent metal. At the same time, side reactions may be suppressed, and thin film growth rate may be controlled, thereby reducing by-products in the thin film, preventing corrosion or deterioration, and improving the crystallinity of the thin film. In addition, when forming a metal oxide film, a stoichiometric oxidation state may be reached. Even when a thin film is formed on a substrate having a complex structure, step coverage and the thickness uniformity of the thin film may be greatly improved.

The elements having an unshared electron pair may include one or more selected from oxygen (O), sulfur (S), phosphorus (P), and nitrogen (N).

The oxide film reaction surface control agent preferably includes one or more selected from a compound represented by Chemical Formula 1 below and a compound represented by Chemical Formula 2 below. In this case, when forming a thin film, a relatively coarse thin film may be formed by forming a shielding area that does not remain on the thin film. At the same time, side reactions may be suppressed, and thin film growth rate may be controlled, thereby reducing by-products in the thin film, preventing corrosion or deterioration, and improving the crystallinity of the thin film. Even when a thin film is formed on a substrate having a complex structure, step coverage and the thickness uniformity of the thin film may be greatly improved.

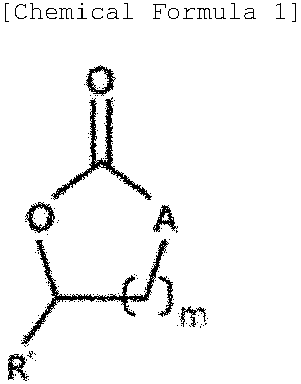

In Chemical Formula 1, R' is hydrogen, an alkyl group having 1 to 5 carbon atoms, an alkene group having 1 to 5 carbon atoms, or an alkoxy group having 1 to 5 carbon atoms, A is oxygen (O), sulfur (S), phosphorus (P), or nitrogen (N), and m is an integer from 0 to 2.

The linear compound containing three or more elements having an unshared electron pair may be a compound represented by Chemical Formula 2 below.

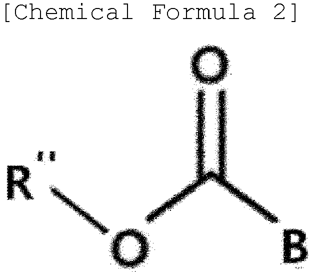

In Chemical Formula 2, R'' is hydrogen, an alkyl group having 1 to 5 carbon atoms, an alkene group having 1 to 5 carbon atoms, or an alkoxy group having 1 to 5 carbon atoms,

B is -OH, -OCH₃, -OCH₂CH₃, -CH₂CH₃, -SH, -SCH₃, or-SCH₂CH₃.

These oxide film reaction surface control agents are provided alone or in the form of a mixed gas. In this case, by-products may be significantly reduced, step coverage may be excellent, thin film density may be improved, and the electrical properties of a thin film may be excellent.

In Chemical Formula 1, R' is hydrogen, an alkyl group having 1 to 5 carbon atoms, or an alkene group having 1 to 5 carbon atoms, preferably hydrogen, an alkyl group having 1 to 3 carbon atoms, or an alkene group having 1 to 3 carbon atoms. In this case, by-products may be significantly reduced, step coverage may be excellent, thin film density may be improved, and the electrical properties, insulation, and dielectric properties of a thin film may be excellent.

In Chemical Formula 1, A is oxygen (O) or sulfur (S), preferably oxygen (O). In this case, by-products may be significantly reduced, step coverage may be excellent, thin film density may be improved, and the electrical properties, insulation, and dielectric properties of a thin film may be excellent.

m is an integer from 0 to 2, preferably 1 or 2.

In Chemical Formula 2, R'' is an alkyl group having 1 to 5 carbon atoms, preferably an alkyl group having 1 to 3 carbon atoms. In this case, by-products may be significantly reduced, step coverage may be excellent, thin film density may be improved, and the electrical properties of a thin film may be excellent.

In Chemical Formula 2, B is -OCH₃, -OCH₂CH₃, -OCHCH₃, -SH, -SCH₃, or -SCH₂CH₃, preferably -OCH₃, -OCH₂CH₃, or -OCHCH₃. In this case, by-products may be significantly reduced, step coverage may be excellent, thin film density may be improved, and the electrical properties of a thin film may be excellent.

As a specific example, the oxide film reaction surface control agent may include one or more selected from compounds represented by Chemical Formulas 1-1 to 1-3 below and compounds represented by Chemical Formulas 2-1 to 2-3 below. In this case, by providing a thin film shielding area, the growth rate of a thin film may be efficiently controlled, by-products may be efficiently removed, and step coverage and film quality may be improved.

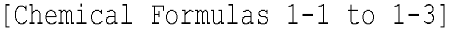

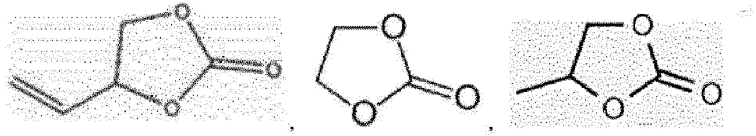

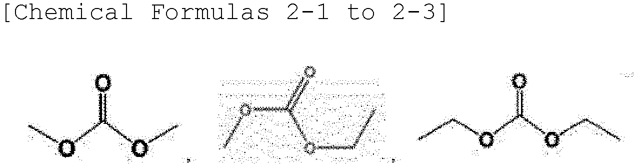

When the oxide film reaction surface control agent is used, a deposition layer having a uniform thickness due to a difference in the adsorption distribution of the activating agent having the above-described structure is formed as a shielding area that does not remain in the thin film, and a relatively coarse thin film is formed. In addition, the growth rate of the formed thin film is greatly reduced. Thus, even when a substrate having a complex structure is used, the uniformity of the thin film may be secured, and step coverage may be greatly improved. In particular, the thickness of a deposited film may be reduced. In addition, by-products, such as O, Si, metals, and metal oxides, and residual carbon, which was not easy to reduce in the past, may be reduced.

The oxide film reaction surface control agent may have a refractive index of 1.365 to 1.48, 1.366 to 1.393, or 1.367 to 1.391. In this case, by controlling a reaction surface in advance to provide an oxide film on the surface of a substrate, reaction rate may be improved. In addition, even when a thin film is formed on a substrate having a complex structure, step coverage and the thickness uniformity of a thin film may be greatly improved. In addition to a thin film precursor, adsorption of by-products may be inhibited. Thus, the surface of the substrate may be effectively protected, and by-products may be effectively removed.

The reaction gas may include O₂, O₃, N₂O, NO₂, H₂O, or O₂ plasma.

The oxide film may be a thin film having two or more layers formed by laminating one or more metals selected from the group consisting of Al, Si, Ti, V, Co, Ni, Cu, Zn, Ga, Ge, Se, Zr, Nb, Mo, Ru, Rh, In, Sn, Sb, Te, Hf, Ta, W, Re, Os, Ir, La, Ce, and Nd.

The oxide film reaction surface control agent may provide a shielding area for thin films.

The shielding area for thin films is characterized in that the shielding area does not remain in the thin film.

Unless otherwise specified, the fact that the shielding area does not remain means that the content of element C is less than 0.1 atom%, the content of Si element is less than 0.1 atom%, the content of N element is less than 0.1 atom%, and the content of halogen elements is less than 0.1 atom% as measured by XPS. Specifically, in secondary-ion mass spectrometry (SIMS) or X-ray photoelectron spectroscopy (XPS), which performs measurement in the depth direction of a substrate, considering the change rate of C, N, Si, and halogen impurities before and after using the oxide film reaction surface control agent under the same deposition conditions, the intensity change rate of each element preferably does not exceed 5 %.

For example, the oxide film may include a halogen compound in an amount of 100 ppm or less.

The oxide film may be used as a diffusion barrier film, an etching stop film, an electrode film, a dielectric film, a gate insulating film, a block oxide film, or a charge trap without being limited thereto.

The oxide film reaction surface control agent and the precursor compound are preferably compounds having a purity of 99.9 % or more, 99.95 % or more, or 99.99 % or more. For reference, when a compound having a purity of less than 99 % is used, impurities may remain in a thin film or side reactions with the precursor or reactants may occur. Thus, it is preferable to use a compound having a purity of 99 % or more.

The oxide film reaction surface control agent is preferably used in an atomic layer deposition (ALD) process. In this case, the oxide film reaction surface control agent may effectively protect the surface of a substrate without interfering with adsorption of the precursor compound, and by-products may be effectively removed.

The oxide film reaction surface control agent is preferably a liquid at room temperature (22 °C), has a density of 0.8 to 2.5 g/cm³ or 0.8 to 1.5 g/cm³, and has a vapor pressure (20 °C) of 0.1 to 300 mmHg or 1 to 300 mmHg. Within this range, a shielding area may be effectively formed, and step coverage, the thickness uniformity of a thin film, and film quality may be improved.

More preferably, the oxide film reaction surface control agent has a density of 0.75 to 2.0 g/cm³ or 0.8 to 1.3 g/cm³ and a vapor pressure (20 °C) of 1 to 260 mmHg. Within this range, a shielding area may be effectively formed, and step coverage, the thickness uniformity of a thin film, and film quality may be improved.

A method of forming an oxide film according to the present invention includes a step of treating the surface of a substrate with the above-described oxide film reaction surface control agent; and a step of sequentially injecting a precursor compound and a reaction gas into a chamber loaded with the substrate to form an oxide film on the surface of the substrate. In this case, by forming a shielding area for thin films on the substrate, thin film deposition rate may be reduced, and thin film growth rate may be appropriately reduced. Thus, even when a thin film is formed on a substrate having a complex structure, step coverage and the thickness uniformity of the thin film may be greatly improved.

In the step of treating the surface of a substrate with the oxide film reaction surface control agent, feeding time of the oxide film reaction surface control agent to the substrate surface per cycle is preferably 0.01 to 10 seconds, more preferably 0.02 to 8 seconds, still more preferably 0.04 to 6 seconds, still more preferably 0.05 to 5 seconds. Within this range, thin film growth rate may be reduced, and step coverage and economics may be excellent.

In the present invention, the feeding time of the precursor compound is based on a flow rate of 0.1 to 500 mg/cycle based on a chamber volume of 15 to 20 L, more specifically, based on a flow rate of 0.8 to 200 mg/cycle based on a chamber volume of 18 L.

As a preferred embodiment, the method of forming an oxide film may include step i) of vaporizing the oxide film reaction surface control agent to treat the surface of a substrate loaded in a chamber; step ii) of primarily purging the inside of the chamber with a purge gas; step iii) of vaporizing a precursor compound to adsorb the precursor compound on the surface of the substrate loaded in the chamber; step iv) of secondarily purging the inside of the chamber with a purge gas; step v) of supplying a reaction gas into the chamber; and step vi) of thirdly purging the inside of the chamber with a purge gas.

In this case, steps i) to vi) may be set as a unit cycle, and the unit cycle may be repeatedly performed until a thin film having a desired thickness is obtained. In one cycle, when the oxide film reaction surface control agent of the present invention is introduced prior to the precursor compound and adsorbed to the substrate, even when deposition is performed at high temperature, thin film growth rate may be appropriately reduced, and by-products may be effectively reduced, thereby reducing the resistivity of a thin film and greatly improving step coverage.

As another preferred embodiment, in the step of controlling a reaction surface, a substrate having the reaction surface may be prepared by applying the oxide film reaction surface control agent onto a substrate loaded in a chamber at 20 to 800 °C.

As a preferred embodiment, according to the method of forming an oxide film according to the present invention, in one cycle, the oxide film reaction surface control agent of the present invention may be introduced prior to a precursor compound to activate the surface of a substrate. Then, the precursor compound may be introduced and adsorbed onto the substrate. In this case, even when a thin film is deposited at high temperature, thin film growth rate may be appropriately reduced, thereby significantly reducing by-products and greatly improving step coverage. In addition, the crystallinity of the thin film may be increased, and thus the resistivity thereof may be reduced. In addition, even when the substrate is applied to a semiconductor device with a large aspect ratio, the thickness uniformity of a thin film may be greatly improved, and the reliability of the semiconductor device may be secured.

For example, in the method of forming an oxide film, when depositing the precursor compound before or after depositing a precursor compound, when necessary, the unit cycle may be repeated 1 to 99,999 times, preferably 10 to 10,000 times, more preferably 50 to 5,000 times, still more preferably 100 to 2,000 times. Within this range, a desired thin film thickness may be obtained, and the effects of the present invention may be sufficiently obtained.

The precursor compound may be a molecule containing one or more selected from the group consisting of Al, Si, Ti, V, Co, Ni, Cu, Zn, Ga, Ge, Se, Zr, Nb, Mo, Ru, Rh, In, Sn, Sb, Te, Hf, Ta, W, Re, Os, Ir, La, Ce, and Nd as a central metal atom (M) and having one or more ligands selected from C, N, O, H, halogen (X), and cyclopentadiene (Cp), and may have a vapor pressure of 1 mTorr to 100 Torr at 25 °C. In this case, despite natural oxidation, the effect of forming a shielding area by the oxide film reaction surface control agent described above may be maximized.

According to the present invention, for example, the chamber may be an ALD chamber, a CVD chamber, a PEALD chamber, or a PECVD chamber.

The thin film may be a silicon oxide film, a titanium oxide film, a hafnium oxide film, a zirconium oxide film, a tungsten oxide film, an aluminum oxide film, a niobium oxide film, or a tellurium oxide film.

According to the present invention, the precursor compound may be vaporized and injected, followed by plasma post-treatment. In this case, thin film growth rate may be improved, and by-products may be reduced.

When the oxide film reaction surface control agent is adsorbed on the substrate, the precursor compound is adsorbed thereon, and then a precursor compound is adsorbed thereon, in the step of purging the unadsorbed oxide film reaction surface control agent, the amount of the purge gas introduced into the chamber is not particularly limited as long as the amount is sufficient to remove the unadsorbed oxide film reaction surface control agent. For example, the amount of the purge gas may be 10 to 100,000 times, preferably 50 to 50,000 times, more preferably 100 to 10,000 times. Within this range, the unadsorbed oxide film reaction surface control agent may be efficiently removed, a thin film may be evenly formed, and deterioration of film quality may be prevented. Here, the input amounts of the purge gas and the oxide film reaction surface control agent are based on one cycle, and the volume of the oxide film reaction surface control agent may mean the volume of the vaporized oxide film reaction surface control agent.

As a specific example, when the oxide film reaction surface control agent is injected at 200 sccm and the flow rate of the purge gas is set to 5,000 sccm in the step of purging the unadsorbed oxide film reaction surface control agent, the injection amount of the purge gas is 25 times the injection amount of the oxide film reaction surface control agent.

In addition, in the step of purging an unadsorbed precursor compound, the amount of the purge gas introduced into the chamber is not particularly limited as long as the amount is sufficient to remove the unadsorbed precursor compound. For example, the amount of the purge gas may be 10 to 10,000 times, preferably 50 to 50,000 times, more preferably 100 to 10,000 times the amount of the precursor compound introduced into the chamber. Within this range, by sufficiently removing the unadsorbed precursor compound, a thin film may be evenly formed, and deterioration of film quality may be prevented. Here, the input amounts of the purge gas and the precursor compound are based on one cycle, and the volume of the precursor compound means the volume of the vaporized precursor compound.

In addition, in the purging step performed immediately after the reaction gas supply step, the amount of the purge gas introduced into the chamber may be, for example, may be 10 to 10,000 times, preferably 50 to 50,000 times, more preferably 100 to 10,000 times the amount of the reaction gas introduced into the chamber. Within this range, the desired effects may be achieved. Here, the input amounts of the purge gas and the reaction gas are based on one cycle.

The precursor compound and a precursor compound may be transferred into the chamber preferably by a VFC method, a DLI method, or an LDS method, more preferably an LDS method.

For example, the substrate loaded in the chamber may be heated to 100 to 650 °C, as a specific example, 150 to 550 °C. The oxide film reaction surface control agent or the precursor compound may be injected onto the substrate in an unheated or heated state. Depending on deposition efficiency, the oxide film reaction surface control agent or the precursor compound may be injected without being heated and then the heating conditions may be adjusted during the deposition process. For example, the oxide film reaction surface control agent or the precursor compound may be injected onto the substrate at 100 to 650 °C for 1 to 20 seconds.

The amount ratio (mg/cycle) of the precursor compound to the oxide film reaction surface control agent input into the chamber may be preferably 1:1.5 to 1:20, more preferably 1:2 to 1:15, still more preferably 1:2 to 1:12, still more preferably 1:2.5 to 1:10. Within this range, step coverage may be significantly improved, and by-products may be significantly reduced.

For example, in the method of forming an oxide film, when the oxide film reaction surface control agent and the precursor compound are used, deposition rate reduction rate expressed by Equation 1 below may be 45 % or more, as a specific example, 48 % or more, preferably 52 % or more. In this case, by using the oxide film reaction surface control agent having the above-described structure, a deposition layer having a uniform thickness may be formed on a thin film. Thus, a relatively coarse thin film may be formed, and thin film growth rate may be significantly reduced. Thus, even when a substrate having a complex structure is used at high temperature, the uniformity of a thin film may be secured, and step coverage may be greatly improved. In particular, the thickness of a deposited film may be reduced. In addition, by-products, such as O, Si, metals, and metal oxides, and the residual amount of carbon, which was not easy to reduce in the past, may be reduced. $\begin{matrix}Deposition rate reduction rate = \left[\left\{\left({DR}_{i}\right)-\left({DR}_{f}\right)\right\}/\left({DR}_{i}\right)\right] \\ \times 100\end{matrix}$

In Equation 1, the deposition rate (DR, Å/cycle) is the deposition rate of a thin film. In deposition of a thin film formed of a precursor and a reactant, the initial deposition rate (DRᵢ) is the deposition rate of a thin film formed without introducing the reaction surface control agent. The final deposition rate (DR_{f}) is the deposition rate of a thin film formed by introducing the oxide film reaction surface control agent during the same process. Here, the deposition rate (DR) is measured at room temperature under normal pressure for a thin film having a thickness of 3 to 30 nm using an ellipsometer, and is expressed in a unit of Å/cycle.

In Equation 1, thin film growth rate per cycle when using or not using the oxide film reaction surface control agent means thin film deposition thickness per cycle (Å/cycle), i.e., deposition rate. For example, the deposition rate may be obtained as an average deposition rate by measuring the final thickness of a thin film at room temperature under normal pressure for a thin film having a thickness of 3 to 30 nm using an ellipsometer and then dividing the measurement result by the total number of cycles.

In Equation 1, "when the oxide film reaction surface control agent is not used" means a case in which a thin film is produced by adsorbing only a precursor compound on a substrate in a thin film deposition process. As a specific example, in the method of forming an oxide film, "when the oxide film reaction surface control agent is not used" means that the step of adsorbing the oxide film reaction surface control agent and the step of purging the unadsorbed oxide film reaction surface control agent are omitted when an oxide film is formed.

In the method of forming an oxide film, the intensity of residual halogen (c/s) in a thin film may be preferably 100,000 or less, more preferably 70,000 or less, still more preferably 50,000 or less, still more preferably 10,000 or less as measured based on a thin film thickness of 100 Å according to SIMS. As a preferred embodiment, the intensity of residual halogen may be 5,000 or less, more preferably 1,000 to 4,000, still more preferably 1,000 to 3,800. Within this range, corrosion and deterioration may be prevented.

In the present invention, purging is performed at preferably 1,000 to 50,000 sccm (standard cubic centimeter per minute), more preferably 2,000 to 30,000 sccm, still more preferably 2,500 to 15,000 sccm. Within this range, thin film growth rate per cycle may be appropriately controlled, and an atomic mono-layer or a layer similar thereto may be formed through deposition, thereby improving film quality.

The atomic layer deposition (ALD) process is very advantageous in fabricating an integrated circuit (IC) that requires a high aspect ratio. In particular, the ALD process has advantages such as excellent conformality, uniformity, and precise thickness control by a self-limiting thin film growth mechanism.

For example, the method of forming an oxide film may be performed at a deposition temperature of 50 to 800 °C, preferably 300 to 700 °C, more preferably 400 to 650 °C, still more preferably 400 to 600 °C, still more preferably 450 to 600 °C. Within this range, ALD process characteristics may be implemented, and a thin film having excellent quality may be grown.

For example, the method of forming an oxide film may be performed under a deposition pressure of 0.01 to 20 Torr, preferably 0.1 to 20 Torr, more preferably 0.1 to 10 Torr, most preferably 0.3 to 7 Torr. Within this range, a thin film having a uniform thickness may be obtained.

In the present invention, the deposition temperature and the deposition pressure may be temperature and pressure formed in the deposition chamber, or may be temperature and pressure applied to the substrate in the deposition chamber.

The method of forming an oxide film may include a step of increasing temperature of the chamber to deposition temperature before introducing the precursor compound into the chamber; and/or a step of purging by injecting an inert gas into the chamber before introducing the precursor compound into the chamber.

In addition, according to the present invention, a thin film manufacturing apparatus capable of realizing the method of forming a thin film may include an ALD chamber, a first vaporizer for vaporizing a precursor compound, a first transfer means for transferring the vaporized precursor compound into the ALD chamber, a second vaporizer for vaporizing a thin film precursor, and a second transfer means for transferring the vaporized thin film precursor into the ALD chamber. Here, vaporizers and transfer means commonly used in the art to which the present invention pertains may be used in the present invention without particular limitation.

As a specific example, the method of forming an oxide film is described as follows. First, a substrate on which a thin film is to be formed is placed in a deposition chamber capable of atomic layer deposition.

The substrate may include semiconductor substrates such as a silicon substrate and a silicon oxide substrate.

A conductive layer or an insulating layer may be formed on the substrate.

To deposit a thin film on the substrate placed in the deposition chamber, the above-described oxide film reaction surface control agent and a precursor compound or a mixture of the precursor compound and a non-polar solvent are prepared.

Then, the prepared oxide film reaction surface control agent is injected into the vaporizer to change the oxide film reaction surface control agent into a vapor phase, and the vaporized oxide film reaction surface control agent is transferred to the deposition chamber and adsorbed onto the substrate. Then, purging is performed to remove the unadsorbed oxide film reaction surface control agent.

Then, the prepared precursor compound or the prepared mixture of the precursor compound and a non-polar solvent (composition for thin film formation) is injected into the vaporizer to change the precursor compound or the mixture into a vapor phase, and the vaporized precursor compound or mixture is transferred to the deposition chamber and adsorbed onto the substrate. Then, purging is performed to remove the unadsorbed precursor compound/the unadsorbed composition for thin film formation.

In the present invention, the order of the process of adsorbing the precursor compound onto the substrate and performing purging to remove the unadsorbed oxide film reaction surface control agent and the process of adsorbing the precursor compound onto the substrate and performing purging to remove the unadsorbed precursor compound may be changed as needed.

In the present invention, for example, the oxide film reaction surface control agent, the precursor compound, the precursor compound (composition for thin film formation), or the like may be transferred into the deposition chamber by a vapor flow control (VFC) method of transferring volatilized gas using a mass flow controller (MFC) or a liquid delivery system (LDS) for transferring liquid using a liquid mass flow controller (LMFC), preferably the LDS.

In this case, a mixed gas containing one or more selected from the group consisting of argon (Ar), nitrogen (N₂), and helium (He) may be used as a transport gas or dilution gas for transporting the oxide film reaction surface control agent, the precursor compound, the precursor compound, or the like onto the substrate, without being limited thereto.

In the present invention, for example, an inert gas may be used as the purge gas. Preferably, the transport gas or the dilution gas may be used as the purge gas.

Next, a reaction gas is supplied. Reaction gases commonly used in the art to which the present invention pertains may be used in the present invention without particular limitation. Preferably, the reaction gas may include a nitrifying agent. The oxidizer reacts with the precursor compound adsorbed on the substrate to form an oxide film.

Preferably, the oxidizer (reaction gas) may be O₂, O₃, N₂O, NO₂, H₂O, or O₂ plasma.

Next, the remaining unreacted reaction gas is purged using an inert gas. Accordingly, in addition to excess reaction gas, by-products may also be removed.

As described above, according to the method of forming an oxide film, for example, the step of treating a substrate with an oxide film reaction surface control agent, the step of shielding a precursor compound on the substrate, the step of purging the unadsorbed oxide film reaction surface control agent, the step of adsorbing the precursor compound/a composition for thin film formation on the substrate, the step of purging the unadsorbed precursor compound/the composition for thin film formation, the step of supplying a reaction gas, and the step of purging the remaining reaction gas may be set as a unit cycle, and the unit cycle may be repeated to form a thin film having a desired thickness.

As another example, according to the method of forming an oxide film, the step of adsorbing a precursor compound/a composition for thin film formation on a substrate, the step of purging the unadsorbed precursor compound/the unadsorbed composition for thin film formation, the step of adsorbing an oxide film reaction surface control agent on the substrate, the step of purging the unadsorbed oxide film reaction surface control agent, the step of supplying a reaction gas, and the step of purging the remaining reaction gas may be set as a unit cycle, and the unit cycle may be repeated to form a thin film having a desired thickness.

For example, the unit cycle may be repeated 1 to 99,999 times, preferably 10 to 1,000 times, more preferably 50 to 5,000 times, still more preferably 100 to 2,000 times. Within this range, the desired thin film properties may be effectively expressed.

In addition, the present invention provides a semiconductor substrate, and the semiconductor substrate is formed by the method of forming an oxide film of the present invention. In this case, the step coverage, thickness uniformity, density, and electrical properties of a thin film may be excellent.

For example, the thickness of the thin film (oxide film) may be 0.1 to 20 nm, preferably 0.5 to 20 nm, more preferably 1.5 to 15 nm, still more preferably 2 to 10 nm. Within this range, thin film properties may be excellent.

The thin film may have a carbon impurity content of preferably 5,000 counts/sec or less or 1 to 3,000 counts/sec, still more preferably 10 to 1,000 counts/sec, still more preferably 50 to 500 counts/sec. Within this range, thin film properties may be excellent, and thin film growth rate may be reduced.

For example, the thin film may have a step coverage of 90 % or more, preferably 92 % or more, more preferably 95 % or more. Within this range, since even a thin film having a complicated structure may be easily deposited on a substrate, the thin film may be applied to a next-generation semiconductor device.

The produced thin film has a thickness of preferably 20 nm or less, has a dielectric constant of 5 to 29 based on a thin film thickness of 10 nm, has a carbon, nitrogen, and halogen content of 5,000 counts/sec or less, and has a step coverage of 90 % or more. Within this range, the thin film is suitable as a dielectric film or a blocking film, without being limited thereto.

For example, when necessary, the oxide film may have a multilayer structure having two or more layers, preferably a multilayer structure having two or three layers. As a specific example, the multilayer structure having two layers may be a lower layer-middle layer structure, and the multilayer structure having three layers may be a lower layer-middle layer-upper layer structure.

For example, the lower layer may include one or more selected from the group consisting of Si, SiO₂, MgO, Al₂O₃, CaO, ZrSiO₄, ZrO₂, HfSiO₄, Y₂O₃, HfO₂, LaLuO₂, Si₃N₄, SrO, La₂O₃, Ta₂O₅, BaO, and TiO₂.

For example, the middle layer may include TiₓN_{y}, preferably TN.

For example, the upper layer may include one or more selected from the group consisting of W and Mo.

The semiconductor substrate may be low resistance metal gate interconnects, a high aspect-ratio 3D metal-insulator-metal (MIM) capacitor, a DRAM trench capacitor, 3D gate-all-around (GAA), or a 3D NAND flash memory.

Hereinafter, the present invention will be described in more detail with reference to the following preferred examples and drawings. However, these examples and drawings are provided for illustrative purposes only and should not be construed as limiting the scope and spirit of the present invention. In addition, it will be apparent to those skilled in the art that various changes and modifications may be made without departing from the spirit and scope of the present invention, and such changes and modifications are also within the scope of the appended claims.

### [Examples]

### Examples 1 to 7 and Comparative Examples 1 to 10

An ALD deposition process was performed using the components and process conditions shown in Table 1 below according to the process shown in FIG. 1 below.

FIG. 1 below is a diagram schematically showing a deposition process sequence according to the present invention based on 1 cycle.

While argon was introduced into the chamber at 5,000 ml/min, a vacuum pump was used to adjust pressure in the chamber to 1.5 Torr to form a rare inert atmosphere.

The oxide film reaction surface control agent shown in Table 1 below was put in a canister, partial pressure and temperature were adjusted according to the predetermined injection amount (mg/cycle), and the oxide film reaction surface control agent was injected into a deposition chamber loaded with a substrate for 1 second and was applied to the substrate. Then, purging was performed in the chamber for 10 seconds.

Subsequently, the precursor compound was put into the canister and introduced into the deposition chamber using a vapor flow controller (VFC) as shown in Table 1 below, and purging was performed in the chamber for 10 seconds.

Next, the concentration of O₃ in O₂ as a reactive gas was set to 200 g/m³ and O₃ was introduced into the deposition chamber as shown in Table 1, and purging was performed in the chamber for 10 seconds. At this time, the substrate on which a thin film was to be formed was heated according to the temperature conditions shown in Table 1 below.

This process was repeated 100 to 400 times to form a self-limiting atomic layer thin film having a thickness of 10 nm.

For the obtained thin films of Examples 1 to 7 and Comparative Examples 1 to 10, deposition rate reduction rate (D/R reduction rate) and SIMS C impurities were measured in the following methods, and the results are shown in Table 1 below.

* Deposition rate reduction rate (D/R (dep. rate) reduction rate): The deposition rate reduction rate means the ratio of decrease in the deposition rate after introducing a shielding material compared to the D/R before introducing the oxide film reaction surface control agent. The deposition rate reduction rate was calculated as a percentage using a measured A/cycle value.

Specifically, the thickness of a produced thin film was measured using an ellipsometer capable of measuring optical properties such as the thickness or refractive index of a thin film using the polarization characteristics of light. The thickness of the thin film deposited per cycle was calculated by dividing the thickness value by the number of cycles. Based on this result, reduction rate in thin film growth rate was calculated using Equation 1 below.$\begin{matrix}Deposition rate reduction rate = \left[\left\{\left({DR}_{i}\right)-\left({DR}_{f}\right)\right\}/\left({DR}_{i}\right)\right] \\ \times 100\end{matrix}$

In Equation 1, the deposition rate (DR, Å/cycle) is the deposition rate of a thin film. In deposition of a thin film formed of a precursor and a reactant, the initial deposition rate (DRᵢ) is the deposition rate of a thin film formed without introducing the reaction surface control agent. The final deposition rate (DR_{f}) is the deposition rate of a thin film formed by introducing the oxide film reaction surface control agent during the same process. Here, the deposition rate (DR) is measured at room temperature under normal pressure for a thin film having a thickness of 3 to 30 nm using an ellipsometer, and is expressed in a unit of Å/cycle.

* Non-uniformity: Among the thicknesses of the thin films measured using an ellipsometer, the maximum and minimum thicknesses were selected. Then, non-uniformity was calculated using Equation 2 below, and the results are shown in Table 1 below. Specifically, the thicknesses of four edge portions and one central portion were measured on a 300 mm wafer.$Non - uniformity \left(%\right) = \left[\left\{\left(\begin{matrix}maximum thickness - minimum \\ thickness\end{matrix}\right)/2\right\}\times average thickness\right] \times 100$
* Secondary-ion mass spectrometry (SIMS) C impurities: The C impurity value was confirmed in the SIMS graph by considering C impurities content (counts) when sputter time was 50 seconds, when a thin film was penetrated in the axial direction by an ion sputter and contamination on the surface layer of a substrate was minimal.
* Step coverage (%): Using thin films deposited on a substrate having a complex structure with an aspect ratio of 22:1 according to Examples 1 to 7 and Comparative Examples 1 to 10, cutting was performed in the horizontal direction at a position of 100 nm in the downward direction from the top of the thin film (left figure) and a position of 100 nm in the upward direction from the bottom thereof (right figure), a TEM image of the specimen was obtained, and step coverage was calculated according to Equation 3 below.
$Step coverage \left(%\right) = \left(\begin{matrix}Thickness deposited on lower \\ inner wall / Thickness deposited on upper inner wall\end{matrix}\right) \times 100$

Specifically, for a substrate with a complex structure having an aspect ratio of 22:1 and having an upper diameter of 90 nm, a lower diameter of 65 nm, and a via hole depth of about 2,000 nm, a deposition process was performed using diffusion enhancing material application conditions. Then, to check thickness uniformity and step coverage deposited inside a vertically formed via hole, cutting was performed in the horizontal direction at a position of 100 nm in the downward direction from the top and a position of 100 nm in the upward direction from the bottom to prepare a specimen. Transmission electron microscopy (TEM) analysis was performed, and the results are shown in Table 1 and FIGS. 2 and 3 below.

**[Table 1]**

| No. | Pre cur sor | Rea ction gas | Oxide film reaction surface control agent (Chemical Formula No.) | Depo siti on temp erat ure | Prec ursor injectio n cond itions | Reac tion gas injectio n cond itions | Oxide film reac tion surf ace control agent injectio n cond itions | Depo sition rate (Å/c ycle ) | Nonunit ormity (%) | Equa tion 1 calculat ion resu lt | SIMS C anal ysis (cou nts/ s) | Ste p cov era ge (22 : 1 S/C ) (%) |
|---|---|---|---|---|---|---|---|---|---|---|---|---|
| Comp arat ive Exam ple 1 | CpH f | O₃ | - | 420 °C | VFC, 3s, 100 sccm | 5s, 500 sccm | - | 0.93 | 1.22 | - | 428. 9 | 23. 6 |
| Comp arat ive Exam ple 2 | CpH f | O₃ | Tetrah ydrofu ran | 400 °C | VFC, 3s, 100 sccm | 5s, 500 sccm | 30 mg/c ycle | 0.85 | 3.87 | 9 % | 524. 3 | 75. 6 |
| Comp arat ive Exam ple 3 | CpH f | O₃ | Cyclop entyl methyl ether | 400 °C | VFC, 3s, 100 sccm | 5s, 500 sccm | 30 mg/c ycle | 0.79 | 4.14 | 15 % | 537. 5 | 70. 7 |
| Comp arat ive Exam ple 4 | CpH f | O₃ | Trimet hyl orthoa cetate | 400 °C | VFC, 3s, 100 sccm | 5s, 500 sccm | 30 mg/c ycle | 0.58 | 23.8 2 | 37 % | 600. 9 | 84. 9 |
| Comp arat ive Exam ple 5 | CpH f | O₃ | Monogl yme | 400 °C | VFC, 3s, 100 sccm | 5s, 500 sccm | 30 mg/c ycle | 0.67 | 6.84 | 28 % | 583. 7 | N/A |
| Comp arat ive Exam ple 6 | CpH f | O₃ | Methyl propio nate | 400 °C | VFC, 3s, 100 sccm | 5s, 500 sccm | 30 mg/c ycle | 0.83 | 9.53 | 11 % | 1008 .5 | 87. 3 |
| Comp arat ive Exam ple 7 | CpH f | O₃ | γ-Valero lacton e | 400 °C | VFC, 3s, 100 sccm | 5s, 500 sccm | 30 mg/c ycle | 0.84 | 3.42 | 9 % | 708. 5 | N/A |
| Comp arat ive | CpH f | O3 | Aceton e | 400 °C | VFC, 3s, | 5s, 500 sccm | 30 mg/c ycle | 0.79 | 6.63 | 15 % | 753. 4 | 73. 2 |
| Exam ple 8 | | | | | 100 sccm | | | | | | | |
| Comp arat ive Exam ple 9 | CpH f | O₃ | Acetyl aceton e | 400 °C | VFC, 3s, 100 sccm | 5s, 500 sccm | 30 mg/c ycle | 0.58 | 11.0 6 | 38 % | 935. 6 | N/A |
| Exam ple 1 | CpH f | O₃ | Chemic al Formul a 2-1 | 420 °C | VFC, 3s, 100 sccm | 5s, 500 sccm | 15 mg/c ycle | 0.10 | 2.51 | 89 % | 387. 9 | 110 .5 |
| Exam ple 2 | CpH f | O₃ | Chemic al Formul a 2-2 | 400 °C | VFC, 3s, 100 sccm | 5s, 500 sccm | 20 mg/c ycle | 0.21 | 2.08 | 77 % | 393. 7 | N/A |
| Exam ple 3 | CpH f | O₃ | Chemic al Formul a 2-3 | 400 °C | VFC, 3s, 100 sccm | 5s, 500 sccm | 10 mg/c ycle | 0.32 | 1.90 | 66 % | 329. 6 | 94. 1 |
| Exam ple 4 | CpH f | O₃ | Chemic al Formul a 1-3 | 400 °C | VFC, 3s, 100 sccm | 5s, 500 sccm | 15 mg/c ycle | 0.37 | 3.60 | 60 % | 408. 8 | N/A |
| Comp arat ive Exam ple 10 | TMA | O₃ | Al₂O₃ | 400 °C | VFC, 2s, 100 sccm | 5s, 300 sccm | - | 0.75 | 1.20 | - | 73.2 | 95. 0 |
| Exam ple 5 | TMA | O₃ | Chemic al Formul a 2-1 | 400 °C | VFC, 2s, 100 sccm | 5s, 300 sccm | 15 mg/c ycle | 0.26 | 2.86 | 65 % | 54.1 | 101 .0 |
| Exam ple 6 | TMA | O₃ | Chemic al Formul a 2-2 | 400 °C | VFC, 2s, 100 sccm | 5s, 300 sccm | 25 mg/c ycle | 0.30 | 2.90 | 60 % | 53.8 | 100 .0 |
| Exam ple 7 | TMA | O₃ | Chemic al Formul a 2-3 | 400 °C | VFC, 2s, 100 sccm | 5s, 300 sccm | 20 mg/c ycle | 0.35 | 3.73 | 53 % | 56.8 | 98. 0 |

In Table 1, CpHf is an abbreviation for tris(dimethylamido)cyclopentadienyl hafnium, and TMA is an abbreviation for trimethyl aluminum.

As shown in Table 1, in the case of Examples 1 to 7 using the oxide film reaction surface control agent and the precursor compound according to the present invention, compared to Comparative Example 1 not using the oxide film reaction surface control agent and the precursor compound, deposition rate reduction rate was significantly improved, impurities were reduced, and step coverage was excellent.

In addition, in the case of Examples 1 to 7 using the oxide film reaction surface control agent according to the present invention, compared to Comparative Examples 2 to 10 using different types of unsuitable materials, deposition rate reduction rate was significantly improved, impurities were reduced, and step coverage was excellent.

Specifically, Comparative Examples 2 to 10 not using the oxide film reaction surface control agent of the present invention exhibited a deposition rate reduction rate of 9 to 38 % calculated based on difference in growth rate. On the other hand, Examples 1 to 7 using the oxide film reaction surface control agent of the present invention exhibited a deposition rate reduction rate of 53 to 89 % calculated based on difference in growth rate, showing superiority in terms of deposition rate reduction rate.

Based on these results, it is expected that effective step coverage may be implemented even on a pattern substrate with a high aspect ratio.

As shown in FIGS. 2 and 3, in the case of Comparative Examples 2, 3, 4, 6, 8, and 10, step coverage is 23.6 % or more, and a maximum step coverage of 95 % is observed. In the case of Examples 1, 3, 5, 6, and 7 according to the present invention, a minimum step coverage of 94.1 % and a maximum step coverage of 110.5 % are observed, showing superiority in terms of step coverage. Accordingly, when using the oxide film reaction surface control agent of the present invention, it can be seen that both the thickness of an upper portion and the thickness of a lower portion are increased.

## Claims

1. An oxide film reaction surface control agent, comprising one or more compounds selected from a cyclic compound containing three or more elements having an unshared electron pair and a linear compound containing three or more elements having an unshared electron pair,
wherein the oxide film reaction surface control agent controls a reaction surface of an oxide film formed of one or more precursor compounds selected from a trivalent metal, a tetravalent metal, a pentavalent metal, and a hexavalent metal.

2. The oxide film reaction surface control agent according to claim 1, wherein the elements having an unshared electron pair comprise one or more selected from oxygen (O), sulfur (S), phosphorus (P), and nitrogen (N).

3. The oxide film reaction surface control agent according to claim 1, wherein the cyclic compound containing three or more elements having an unshared electron pair is a compound represented by Chemical Formula 1 below: 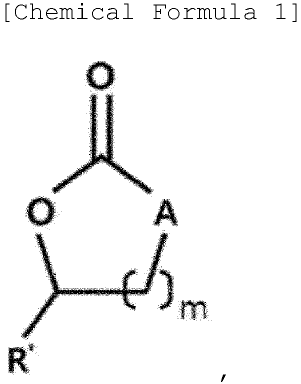 wherein R' is hydrogen, an alkyl group having 1 to 5 carbon atoms, an alkene group having 1 to 5 carbon atoms, or an alkoxy group having 1 to 5 carbon atoms, A is oxygen (O), sulfur (S), phosphorus (P), or nitrogen (N), and m is an integer from 0 to 2.

4. The oxide film reaction surface control agent according to claim 1, wherein the linear compound containing three or more elements having an unshared electron pair is a compound represented by Chemical Formula 2 below: 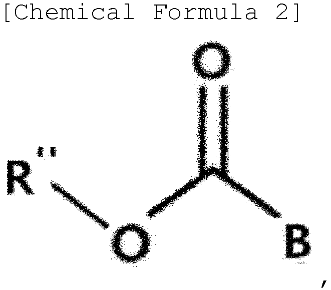 wherein R' ' is hydrogen, an alkyl group having 1 to 5 carbon atoms, an alkene group having 1 to 5 carbon atoms, or an alkoxy group having 1 to 5 carbon atoms, and B is -OH, - OCH₃, -OCH₂CH₃, -CH₂CH₃, -SH, -SCH₃, or -SCH₂CH₃.

5. The oxide film reaction surface control agent according to claim 1, wherein the oxide film reaction surface control agent has a refractive index of 1.365 to 1.48.

6. The oxide film reaction surface control agent according to claim 1, wherein the metal controls a reaction surface of an oxide film formed of one or more precursor compounds selected from the group consisting of Al, Si, Ti, V, Co, Ni, Cu, Zn, Ga, Ge, Se, Zr, Nb, Mo, Ru, Rh, In, Sn, Sb, Te, Hf, Ta, W, Re, Os, Ir, La, Ce, and Nd.

7. The oxide film reaction surface control agent according to claim 1, wherein the oxide film reaction surface control agent comprises one or more selected from compounds represented by Chemical Formulas 1-1 to 1-3 below and compounds represented by Chemical Formulas 2-1 to 2-3 below:

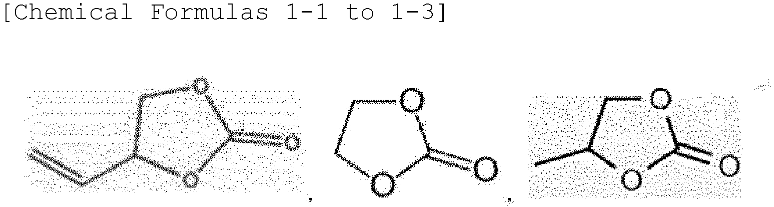

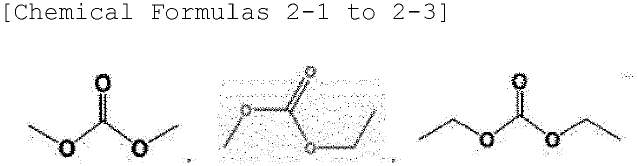

8. A method of forming an oxide film, comprising:
treating a surface of a substrate with the oxide film reaction surface control agent according to any one of claims 1 to 7; and
sequentially injecting a precursor compound and a reaction gas into a chamber loaded with the substrate to form an oxide film on the surface of the substrate.

9. The method according to claim 8, wherein the chamber is an ALD chamber, a CVD chamber, a PEALD chamber, or a PECVD chamber.

10. The method according to claim 8, wherein the treating is performed by applying the oxide film reaction surface control agent at 20 to 800 °C onto the substrate loaded in the chamber.

11. The method according to claim 8, wherein the oxide film reaction surface control agent and the precursor compound are transferred into the chamber by a VFC method, a DLI method, or an LDS method.

12. The method according to claim 8, wherein the oxide film is a silicon oxide film, a titanium oxide film, a hafnium oxide film, a zirconium oxide film, a tungsten oxide film, an aluminum oxide film, a niobium oxide film, or a tellurium oxide film.

13. A semiconductor substrate, comprising the oxide film formed by the method of forming an oxide film according to claim 8.

14. The semiconductor substrate according to claim 13, wherein the oxide film has a multilayer structure having two or more layers.

15. A semiconductor device, comprising the semiconductor substrate according to claim 13.
